Europäisches Patentamt

European Patent Office

Office européen des brevets

(19)

(11) Numéro de publication: **0 252 775 B1**

(12) **FASCICULE DE BREVET EUROPEEN**

(45) Date de publication du fascicule du brevet:
27.06.90

(51) Int. Cl.⁵: **C30B 29/52**, C30B 11/00

(21) Numéro de dépôt: 87401134.9

(22) Date de dépôt: 20.05.87

(54) **Superalliage monocristallin à base de nickel, notamment pour aubes de turbomachine.**

(30) Priorité: 04.06.86 FR 8608068

(43) Date de publication de la demande:
13.01.88 Bulletin 88/2

(45) Mention de la délivrance du brevet:
27.06.90 Bulletin 90/26

(84) Etats contractants désignés:
CH DE GB IT LI NL SE

(56) Documents cités:
DE-A- 2 037 020
FR-A- 2 555 204
GB-A- 2 071 695

(73) Titulaire: OFFICE NATIONAL D'ETUDES ET DE RECHERCHES AEROSPATIALES(O.N.E.R.A.), 29, avenue de la Division Leclerc, F-92322 Châtillon Cédex(FR)

(72) Inventeur: Khan, Tasadduq, 18, parc de Diane, F-78350 Jouy en Josas(FR)
Inventeur: Caron, Pierre, 7,rue de Champagne, F-91940 Les Ulis(FR)
Inventeur: Raffestin, Jean-Louis, 10, Résidence du Bois du Roi, F-91940 Les Ulis(FR)

(74) Mandataire: Netter, André et al, Cabinet NETTER, 40, rue Vignon, F-75009 Paris(FR)

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

L'invention concerne un superalliage à base de nickel adapté à la solidification monocristalline notamment d'aubes mobiles de turbomachine.

De tels alliages, définis par des compositions particulières, sont décrits dans le brevet FR-A 2 555 204 (& EP-A 143 694) au nom du Demandeur. Ces alliages se comparent favorablement, en ce qui concerne la résistance au fluage à haute température, aux meilleurs superalliages connus antérieurement, et présentent par rapport à ceux-ci des masses volumiques significativement inférieures.

Le brevet précité mentionnait en particulier le superalliage le plus performant alors en production, connu sous la référence PWA 1422 (DS 200 + Hf), dont la masse volumique est 8,55 g/cm³. Il s'agit d'un alliage à grains colonnaires obtenu par solidification dirigée, présentant une bonne résistance aux sollicitations dans une direction parallèle aux joints de grains.

Ce brevet faisait également référence à un alliage résultant de récents travaux tendant à la mise au point de compositions nouvelles adaptées à l'élaboration d'aubes monocristallines par solidification dirigée. Cet alliage, désigné sous la référence PWA 1480 (ou alliage 454), possède une masse volumique de 8,7 g/cm³.

La résistance au fluage à chaud de ces alliages connus est obtenue, de façon usuelle, par des additions massives d'éléments réfractaires tels que Ta, W, Mo ou Re. Ainsi, l'alliage 454 contient 12% de Ta et 4% de W, l'alliage DS 200 + Hf contenant 12% de W.

Ces éléments réfractaires jouent un rôle important en diminuant la vitesse de fluage, augmentant proportionnellement les durées de vie en fonctionnement.

Ces éléments ont en effet des vitesses de diffusion très faibles, même à haute température, ce qui conduit à un ralentissement de la vitesse de coalescence de la phase gamma prime, ou phase durcissante, Ni₃ (Al, Ti ...) dont dépend la résistance de l'alliage au fluage à chaud.

Mais ces éléments réfractaires très lourds, s'ils produisent une augmentation de la résistance au fluage à chaud, présentent l'inconvénient d'augmenter simultanément la masse volumique de l'alliage.

On peut concevoir, pour diminuer la masse volumique de l'allage, d'introduire des quantités importantes d'éléments légers, en particulier d'aluminium, mais on aboutit à une précipitation primaire de la phase gamma prime et l'alliage ne peut pas présenter les caractéristiques de fluage requises.

Les travaux du Demandeur dans le domaine des superalliages pour aubes de turbomachine l'ont conduit, pour concilier les exigences contradictoires relatives à la masse volumique et à la résistance au fluage, à optimiser deux paramètres S₁ et S₂ liés respectivement aux teneurs en éléments réfractaires et aux teneurs en éléments qui participent à la formation de la phase durcissante gamma prime, à savoir :

$S_1 = 0,5 \, W + Ta + Mo$

où les symboles littéraux représentent les pourcentages en poids des éléments correspondants, et

$S_2 = Al + Ti + Ta + Nb + V$

où les symboles littéraux représentent les pourcentages en nombre d'atomes des éléments.

Le brevet précité propose des compositions d'alliages pour lesquelles S₁ est compris entre 4 et 9% en poids, et S₂ compris entre 14,9 et 20,6 atomes %.

La part de vanadium entrant dans la somme S₂ procure un élargissement de la fenêtre de traitement thermique, c'est-à-dire de l'intervalle de température entre la fin de la mise en solution de la phase gamma prime et le point de fusion commençante de l'alliage, ce qui peut être avantageux lorsque les traitements thermiques sont effectués dans un cadre industriel.

On s'est abstenu d'incorporer dans les alliages le C, le B et le Zr, évitant ainsi de diminuer la température de fusion commençante de l'alliage et permettant, au cours du traitement thermique, d'amener la pièce à une température suffisamment élevée pour que soit remise en solution la phase gamma prime ainsi que la quasi-totalité de l'eutectique gamma/gamma prime, l'ensemble étant ensuite, au cours du refroidissement, précipité sous forme de fines particules gamma prime.

Le domain de composition pondérale proposé dans le brevet FR-A 2 555 204 est le suivant :

| Co: | 5 à 7% | Cr: | 5 à 10% | Mo: | 0,5 à 2,5% |
|---|---|---|---|---|---|
| W: | 0 à 3,5% | Al: | 6 à 7,5% | Ti: | 1,5 à 2,25% |
| Nb: | 0 à 0,5% | Ta: | 2 à 4% | V: | 0,3 à 0,6% |
| Ni: | complément à 100, | | | | |

sans addition volontaire de
B, C, Zr.

Après élaboration conduisant à l'aube monocristalline, celle-ci est soumise à un traitement thermique de mise en solution de la phase gamma prime. Ce traitement consiste à porter la pièce à une température comprise entre 1290 et 1325°C, selon sa composition, pendant un temps compris entre 30 mintues et quatre heures.

La pièce est alors refroidie à l'air. On applique ensuite un traitement thermique de précipitation de la phase gamma prime comme défini dans le brevet français FR-A 2 503 188 déposé le 3 avril 1981.

Cette précipitation s'effectue à une température supérieure à 1000°C.

On obtient ainsi une distribution régulière des particules gamma prime dont la dimension moyenne est de 0,5 micron.

Ces précipités sont alignés suivant les directions cristallographiques du type <100>.

La masse volumique de ces alliages est de l'ordre de 8,2.

On a constaté que les alliages selon le brevet 2 555 204, qui contiennent au moins 0,3% de vanadium, n'ont pas une excellente tenue à l'oxydation cyclique.

Bien qu'en pratique les alliages pour aubes de turbines soient presque toujours revêtus d'une couche protectrice contre la corrosion et l'oxydation, il est importante que la résistance à l'environnement du matériau nu soit bonne, afin d'éviter une dégradation accélérée de l'alliage lorsque le revêtement est endommagé.

L'invention part de la constatation surprenante que certains alliages exempts de vanadium présentent à la fois des caractéristiques de fluage nettement plus élevées que les alliages décrits dans les exemples 1 et 2 du brevet précité (alliages 1 et 2), et dont la composition est rappelée dans le tableau 1 ci-après, et une très bonne tenue à l'oxydation cyclique à 1100°C comparée à ces alliages 1 et 2. Plus surprenant encore, la fenêtre de traitement thermique de ces alliages sans vanadium est de l'ordre de 20°C, c'est-à-dire pratiquement la même que celle des alliages 1 et 2. On pense que ce résultat est dû principalement à la très faible teneur en bore des alliages selon l'invention (inférieure ou égale à 10 ppm), qui permet pratiquement sans inconvénient de s'affranchir de l'addition de vanadium.

L'invention vise des compositions d'alliages pour lesquelles le paramètres $S_1$ tel que défini ci-dessus est compris entre 7,8 et 8,5% en poids, et le paramètre $S_2$ compris entre 15,6 et 16,88 atomes %.

Plus précisément, la composition pondérale des alliages selon l'invention est la suivante :

Co : 5,0 à 6,0%
W : 4,8 à 5,2%
Cr : 7,8 à 8,3%
Al : 5,8 à 6,1%
Ta : 3,3 à 3,7%
Mo : 2,1 à 2,4%
Ti : 1,8 à 2,2%
B : ≤10 ppm
Zr : ≤50 ppm
Ni : complément à 100%

De préférence, cette composition est sensiblement la suivante :

Co : 5,5%
W : 5,0%
Cr : 8,1%
Al : 6,1%
Ta : 3,4%
Mo : 2,2%
Ti : 2,0%
B : ≤ 10 ppm
Zr : ≤ 50 ppm
Ni : complément à 100%

L'invention a également pour objet un procédé de fabrication d'une pièce, notamment une aube de turbomachine, en un superalliage de la composition ci-dessus, dans lequel on soumet la pièce aux traitements thermiques définis plus haut à propos des alliages du brevet FR-A 2 555 204, et une pièce obtenue par ce procédé.

D'autres caractéristiques et avantages de l'invention ressortiront de la description d'un exemple de réalisation et des dessins annexés dans lesquels :

- les figures 1 et 2 sont des diagrammes donnant des caractéristiques de fluage à chaud de différents alliages,
- la figure 3 est un diagramme montrant la tenue à l'oxydation cyclique à 1100°C de différents alliages.

On a élaboré, par fusion suivie de solidification monocristalline, un alliage dit ONERA 3, dont la composition pondérale est indiquée dans le tableau 1. Le tableau 1 donne également la composition de l'alliage 454 mentionné plus haut et des alliages ONERA 1 et 2 du brevet FR-A 2 555 204.

La masse volumique de l'alliage 3 est sensiblement égale à 8,25 g/cm³.

Tableau 1

| Alliage | PWA 1480 (alliage 454) | ONERA 1 | ONERA 2 | ONERA 3 |
|---------|------------------------|---------|---------|---------|
| Co | 5% | 5% | 5% | 5,55% |
| W | 4% | 4% | 4% | 4,98% |
| Nb | 0 | 0 | 0,5% | 0 |
| Cr | 10% | 7% | 7% | 8,1% |
| Al | 5% | 6% | 6% | 6,07% |
| Ta | 12% | 4% | 3% | 3,36% |
| Mo | 0 | 2,25% | 2,25% | 2,22% |
| Ti | 1,5% | 2% | 2% | 2,02% |
| V | 0 | 0,5% | 0,5% | 0 |
| B | 0 | 0 | 0 | 0 |
| Zr | 0 | 0 | 0 | ≤50 ppm |
| Ni | complément à 100% | | | |

Dans le tableau, l'indication 0 signifie l'absence d'addition volontaire de l'élément considéré.

Les caractéristiques de fluage de l'alliage 3 ont été déterminées après que cet alliage ait subi les traitements thermiques définis plus haut, et comparées à celles des alliages 1 et 2 ayant subi les mêmes traitements et à celles des alliages DS 200 + Hf et 454.

Le tableau 2 donne pour ces cinq alliages les temps nécessaires pour atteindre une déformation de 1% ou la rupture dans différentes conditions de température et de contrainte.

On constate que toutes les valeurs relatives à l'alliage ONERA 3 sont supérieures aux valeurs correspondantes pour tous les autres alliages, l'écart étant particulièrement spectaculaire pour la température d'essai la plus élevée, à savoir 1050°C.

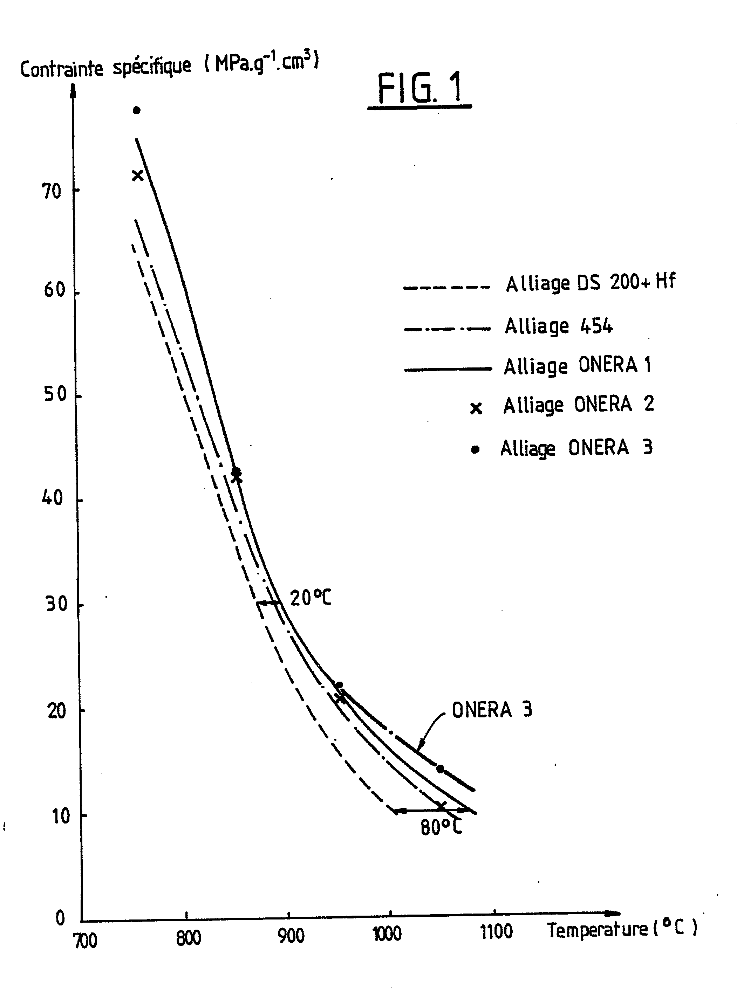

Les courbes de la figure 1 montrent, pour les mêmes alliages, l'évolution en fonction de la température de la contrainte spécifique (rapport contrainte/masse volumique) pour laquelle un allongement de 1% est obtenu en 1000 heures.

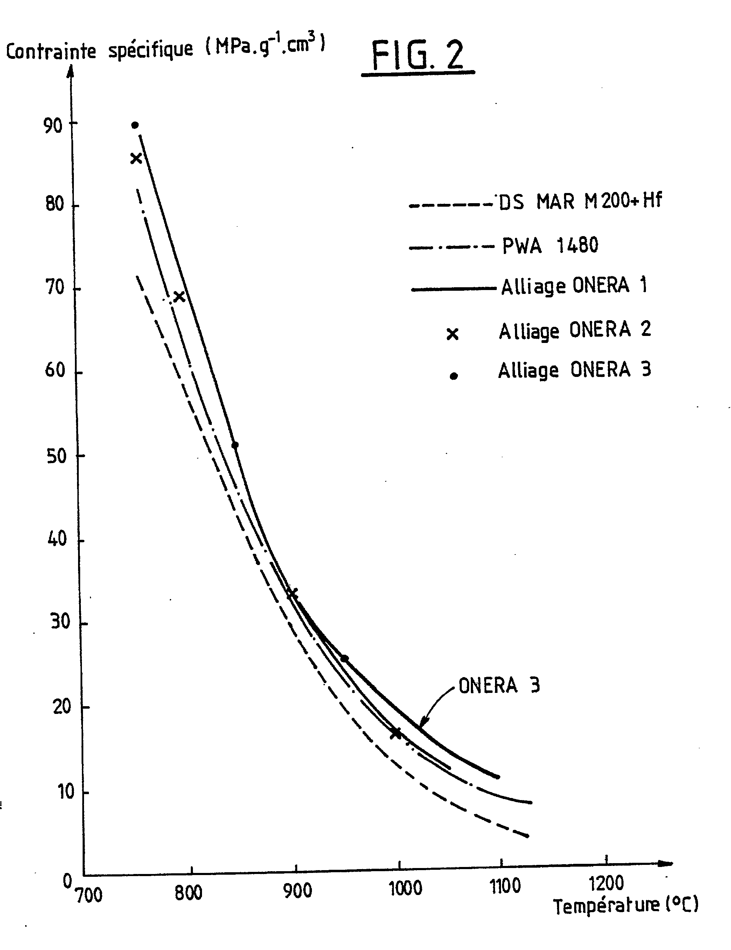

La figure 2 représente des courbes analogues, relatives à la contrainte spécifique pour une rupture en 1000 heures.

Ces courbes confirment la supériorité de l'alliage ONERA 3 par rapport aux alliages connus antérieurement, notamment aux températures élevés.

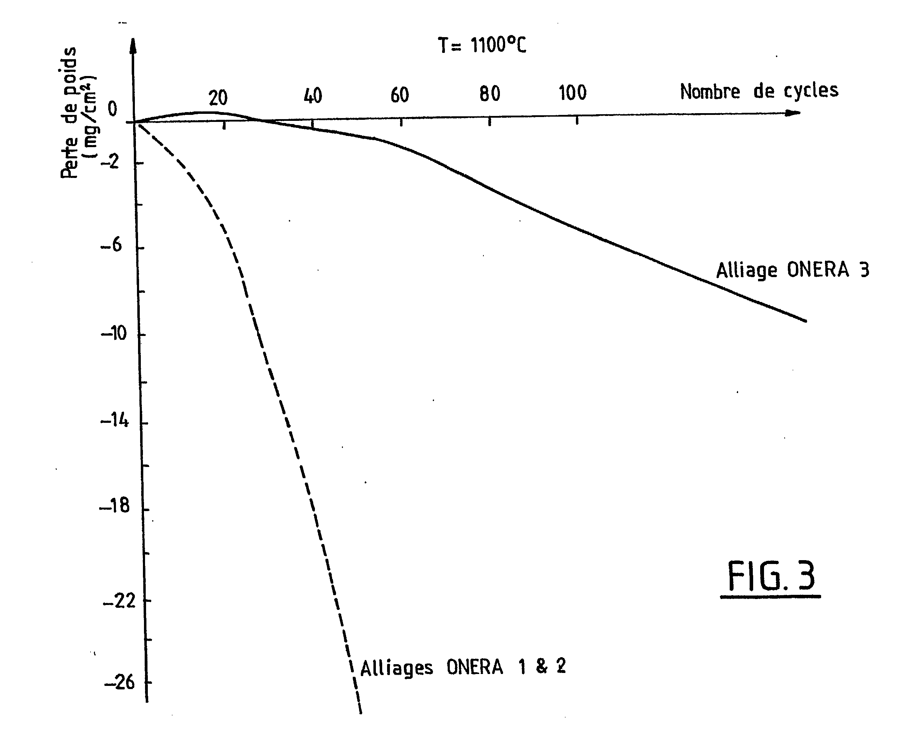

Des essais d'oxydation cyclique à 1100°C ont été effectués pour les alliages ONERA 1 à 3, dans les conditions suivantes : maintien pendant une heure à l'air à 1100°C dans un four, refroidissement jusqu'à environ 200°C en quatre minutes et réchauffement dans le four en huit minutes. Les échantillons sont pesés tous les dix cycles pour déterminer les variations de masse par unité de surface. Les résultats sont donnés dans la figure 3, qui fait apparaître la tenue à l'oxydation modeste des alliages selon le brevet 2 555 204 et l'amélioration très importante procurée à cet égard par la présente invention.

Tableau 2 : Caractéristiques de fluage

| Température (°C) | Contrainte (MPa) | Temps de fluage t | Alliage DS 200 + Hf (PWA 1422) | Alliage 454 (PWA 1480) | Alliage ONERA 1 | Alliage ONERA 2 | Alliage ONERA 3 |
|-----------------|------------------|-------------------|--------------------------------|------------------------|-----------------|-----------------|-----------------|
| 760 | 750 | t pour 1% de déformation | 10 h | 60 h | 72 h | 37 h | 156 h |
| | | t à rupture | 60 à 150 h | 630 h | 847 h | 550 h | 908 h |
| 850 | 500 | t pour 1% de déformation | 40 h | 60 h | 111 h | 84 h | 114 h |
| | | t à rupture | 100 h | 183 h | 331 h | 280 h | 338 h |
| 950 | 240 | t pour 1% de déformation | 45 h | 115 h | 100 h | 105 h | 133 h |
| | | t à rupture | 170 h | 270 h | 250 h | 250 h | 352 h |
| 1050 | 120 | t pour 1% de déformation | 32 h | 182 h | 260 h | 151 h | 696 h |
| | | t à rupture | 100 h | 335 h | 400 h | 260 h | 830 h |

**Revendications**

1.Superalliage à base de nickel destiné notamment à la solidification monocristalline de pièces de turbomachines, caractérisé en ce que sa composition pondérale est la suivante :
Co : 5,0 à 6,0%
W : 4,8 à 5,2%
Cr : 7,8 à 8,3%
Al : 5,8 à 6,1%
Ta : 3,3 à 3,7%
Mo : 2,1 à 2,4%
Ti : 1,8 à 2,2%
B ≤ 10 ppm
Zr ≤ 50 ppm
Ni : complément à 100%

2. Superalliage selon la revendication 1, caractérisé en ce que sa composition pondérale est la suivante :
Co : 5,5%
W : 5,0%
Cr : 8,1%
Al : 6,1%
Ta : 3,4%
Mo : 2,2%
Ti : 2,0%
B : ≤ 10 ppm
Zr : ≤ 50 ppm
Ni : complément à 100%

3. Procédé de fabrication d'une pièce, notamment une aube de turbomachine, en superalliage selon l'une des revendications 1 et 2, caractérisé en ce qu'on porte la pièce à une température suffisante pendant un temps suffisant pour mettre en solution la phase gamma prime, puis à une température supérieure à 1000°C pour provoquer la reprécipitation de la phase gamma prime.

4. Procédé selon la revendication 3, caractérisé en ce que la mise en solution de la phase gamma prime s'effectue à une température comprise entre 1290 et 1325°C.

5. Procédé selon l'une des revendications 3 et 4, caractérisé en ce qu'avant le traitement de redissolution la pièce est obtenue par fusion de l'alliage suivie de solidification monocristalline.

6. Pièce obtenue par le procédé selon l'une des revendications 3 à 5.


**Patentansprüche**

1. Superlegierung auf Nickelbasis, insbesondere für die einkristalline Erstarrung von Turbinenteilen bestimmt, dadurch gekennzeichnet, daß die gewichtsmäßige Zusammensetzung die folgende ist:
Co : 5,0 bis 6,0%
W : 4,8 bis 5,2%
Cr : 7,8 bis 8,3%
Al : 5,8 bis 6,1%
Ta : 3,3 bis 3,7%
Mo : 2,1 bis 2,4%
Ti : 1,8 bis 2,2%
B : ≤ 10 ppm
Zr : ≤ 50 ppm
Ni : Rest

2. Superlegierung nach Anspruch 1, dadurch gekennzeichnet, daß die gewichtsmäßige Zusammensetzung die folgende ist:
Co : 5,5 %
W : 5,0 %
Cr : 8,1 %
Al : 6,1 %
Ta : 3,4 %
Mo : 2,2 %
Ti : 2,0 %
B : ≤ 10 ppm
Zr : ≤ 50 ppm
Ni : Rest

3. Verfahren zur Herstellung eines Werkstückes, insbesondere einer Turbinenschaufel, aus einer Superlegierung nach Anspruch 1 oder 2, dadurch gekennzeichnet, daß das Werkstück lange genug auf ausreichende Temperatur, um die Gamma Strich-Phase aufzulösen, und dann auf eine Temperatur höher als 1000°C gebracht wird, um die Gamma Strich-Phase wiederauszufällen.

4. Verfahren nach Anspruch 3, dadurch gekennzeichnet, daß das Lösen der Gamma Strich-Phase bei einer Temperatur zwischen 1290 und 1325°C erfolgt.

5. Verfahren nach Anspruch 3 oder 4, dadurch gekennzeichnet, daß das Werkstück vor der Wiederauflösungsbehandlung durch Schmelzen der Legierung und nachfolgendes einkristallines Erstarren erhalten wird.

6. Werkstück hergestellt nach dem Verfahren gemäß einem der Ansprüche 3 bis 5.

**Claims**

1. Nickel-based superalloy intended especially for the monocrystalline solidification of parts of turbo-machines, characterized in that its composition by weight is the following:

Co : 5.0 to 6.0%
W : 4.8 to 5.2%
Cr : 7.8 to 8.3%
Al : 5.8 to 6.1%
Ta : 3.3 to 3.7%
Mo : 2.1 to 2.4%
Ti : 1.8 to 2.2%
B : ≤ 10 ppm
Zr : ≤ 50 ppm
Ni: balance to 100%

2. Superalloy according to claim 1, characterized in that its composition by weight is the following:

Co : 5.5%
W : 5.0%
Cr : 8.1%
Al : 6.1%
Ta : 3.4%
Mo : 2.2%
Ti : 2.0%
B : ≤ 10 ppm
Zr : ≤ 50 ppm
Ni : balance to 100%

3. Process for the production of a part, especially a turbo-machine blade, of superalloy according to one of claims 1 and 2, characterized in that the part is brought to a sufficient temperature for a sufficient time to place the gamma prime phase in solution, and then to a temperature greater than 1000°C to cause the reprecipitation of the gamma prime phase.

4. Process according to claim 3, characterized in that the placing of the gamma prime phase in solution is carried out at a temperature within the range between 1290 and 1325°C.

5. Process according to one of claims 3 and 4, characterized in that before the redissolution processing the part is obtained by fusion of the alloy, followed by monocrystalline solidification.

6. Part obtained by the process according to one of claims 3 to 5.

FIG. 1

FIG. 2

Contrainte spécifique ($MPa.g^{-1}.cm^3$)

Température (°C)

-------- DS MAR M 200 + Hf

—·—·— PWA 1480

———— Alliage ONERA 1

×   Alliage ONERA 2

•   Alliage ONERA 3

ONERA 3

T= 1100°C

Perte de poids (mg/cm²)

Nombre de cycles

Alliage ONERA 3

Alliages ONERA 1 & 2

FIG. 3

EP 0 252 775 B1